# EUROPÄISCHE PATENTSCHRIFT

(11) **EP 2 542 905 B1**
(45) Veröffentlichungstag und Bekanntmachung des Hinweises auf die Patenterteilung: **04.06.2014**
(21) Anmeldenummer: 11704428.9
(22) Anmeldetag: 07.02.2011
(51) Int. Cl.: G01R 31/28, G01R 31/317, G01R 31/3185

(54) **VERFAHREN ZUM TESTEN EINES INTEGRIERTEN SCHALTKREISES**
METHOD FOR TESTING AN INTEGRATED CIRCUIT
PROCÉDÉ POUR TESTER UN CIRCUIT INTÉGRÉ

(30) Priorität: 01.03.2010 DE 102010002460
(43) Veröffentlichungstag der Anmeldung: 09.01.2013
(73) Patentinhaber: Robert Bosch GmbH, 70442 Stuttgart (DE)
(72) Erfinder: POINSTINGL, Peter, A-3910 Zwettl (AT); RANDOLL, Helmut, 71665 Vaihingen (DE); KNAUPP, Christoph, A-2700 Wiener Neustadt (AT); BRAUN, Thomas, 70197 Stuttgart (DE); WIEJA, Thomas, 72810 Gomaringen (DE); WIRTH, Steffen, 70469 Stuttgart (DE); DOEHREN, Stefan, 73630 Remshalden-Grunbach (DE); KRAEMER, Ralf, 72070 Tuebingen (DE)
(86) Internationale Anmeldenummer: PCT/EP2011/051706
(87) Internationale Veröffentlichungsnummer: WO 2011/107316

(56) Entgegenhaltungen:
- EP-A1- 1 762 855
- EP-A2- 0 969 290
- DE-A1-102004 043 063

## Beschreibung

Die Erfindung betrifft ein Verfahren zum insbesondere zerstörungsfreien Testen eines integrierten Schaltkreises, der bspw. auf einer Leiterplatte verbaut ist. Dazu wird der integrierte Schaltkreis erfindungsgemäß schaltungstechnisch vorbereitet. Die Erfindung betrifft weiterhin einen solchen integrierten Schaltkreis, der insbesondere zur Durchführung des Verfahrens vorgesehen ist.

### Stand der Technik

Integrierte Schaltkreise (IC: integrated circuits), die bspw. in Steuergeräten von Kraftfahrzeugen eingesetzt werden, werden in der IC-Fertigung im unverpackten Zustand über IC-interne Teststrukturen in sogenannten "built in selftests" geprüft. Dazu ist eine umfangreiche Teststruktur auf dem IC integriert, in der ausgehend von einem TAP (test access port) über interne Bus-Systeme jeder Punkt der Schaltung erreicht und getestet werden kann. Diese Teststruktur wird für den Test mittels Nadeladaptern kontaktiert. Nach dem Test werden die ICs verpackt, d.h. in einem Gehäuse vergossen, so dass der TAP nicht mehr für weitere Tests zugänglich ist.

Aus der Druckschrift DE 10 2004 043 063 A1 ist ein Halbleiter-Bauelement mit einer Test-Schnittstellen-Einrichtung bekannt. Dabei kann mindestens ein Pin des Halbleiter-Bauelements in einem Normalbetriebs-Modus des Halbleiter-Bauelements als Applikations-Funktions-Pin und in einem ersten Test-Betriebs-Modus als Test-Pin zur Ein- oder Ausgabe entsprechender Test-Signale betrieben werden.

Heute ist es üblich, zur Befundung ein IC aus dem Steuergerät auszulöten, wobei das Steuergerät zerstört wird, und auf einem IC-Tester funktional zu prüfen. Wegen der hohen Zahl an kombinatorischen Zuständen ist die so erreichbare Testtiefe nicht sehr hoch. Aufgrund der immer kleineren Strukturen bringt das Auslöten zunehmend die Gefahr der Zerstörung des Prüflings mit sich.

Ein weiterer Befundungsschritt erfordert das Auffräsen des ICs und die Kontaktierung des TAP. Der Aufwand dafür ist hoch, das Zerstörungsrisiko des Prüflings ebenfalls. Mit dem beschriebenen Verfahren werden die ICs im eingebauten Zustand geprüft ohne Gefahr, zerstört zu werden.

Hierzu ist bekannt, den TAP aller ICs in einer Schaltung mittels zusätzlicher Kontakte an jedem IC nach außen zu führen und auf der Leiterplatte über ein eigenes Bus-System mit einem Rechner zu verbinden, der diese IC-Tests steuern kann. Dies verursacht allerdings erhöhte Kosten jedes ICs für die Kontakte sowie Kosten für die extra Leiterbahnen, so dass dieses Verfahren für Großserienanfertigungen nicht in Frage kommt.

Es soll daher erreicht werden, dass IC-Tests auch im eingebauten Zustand funktionieren müssen, d. h. wenn das IC im Steuergerät und das Steuergerät im Fahrzeug eingebaut ist. Außerdem soll erreicht werden, dass die Testbarkeit hergestellt ist, ohne dass im Steuergerät ein zusätzlicher Testbus mit entsprechenden Kosten, bspw. durch zusätzliche Leiterbahnfläche und Anschlusspins, erforderlich wird.

### Offenbarung der Erfindung

Vor diesem Hintergrund werden ein Verfahren zum Testen eines integrierten Schaltkreises gemäß Anspruch 1 und ein integrierter Schaltkreis mit den Merkmalen des Anspruchs 5 vorgeschlagen. Weitere Ausgestaltungen der Erfindung ergeben sich aus den abhängigen Patentansprüchen und der Beschreibung.

Mit dem beschriebenen Verfahren ist es möglich, einen IC-Test auch im eingebauten Zustand durchzuführen. Ein zusätzlicher Testbus ist nicht erforderlich.

Weitere Vorteile und Ausgestaltungen der Erfindung ergeben sich aus der Beschreibung und den beiliegenden Zeichnungen.

Es versteht sich, dass die voranstehend genannten und die nachstehend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen.

### Kurze Beschreibung der Zeichnungen

- Figur 1: zeigt einen integrierten Schaltkreis gemäß dem Stand der Technik.
- Figur 2: zeigt eine Ausführungsform des vorgestellten Schaltkreises.
- Figur 3: zeigt den Schaltkreis aus Figur 2 bei einem Test im Halbleiterwerk.
- Figur 4: zeigt den Schaltkreis aus Figur 2 bei dessen Steuerung im Steuergerät.
- Figur 5: zeigt den Schaltkreis aus Figur 2 beim erfindungsgemäßen Test im eingebauten Zustand.

Die Erfindung ist anhand von Ausführungsformen in den Zeichnungen schematisch dargestellt und wird unter Bezugnahme auf die Zeichnungen ausführlich beschrieben.

### Ausführungsformen der Erfindung

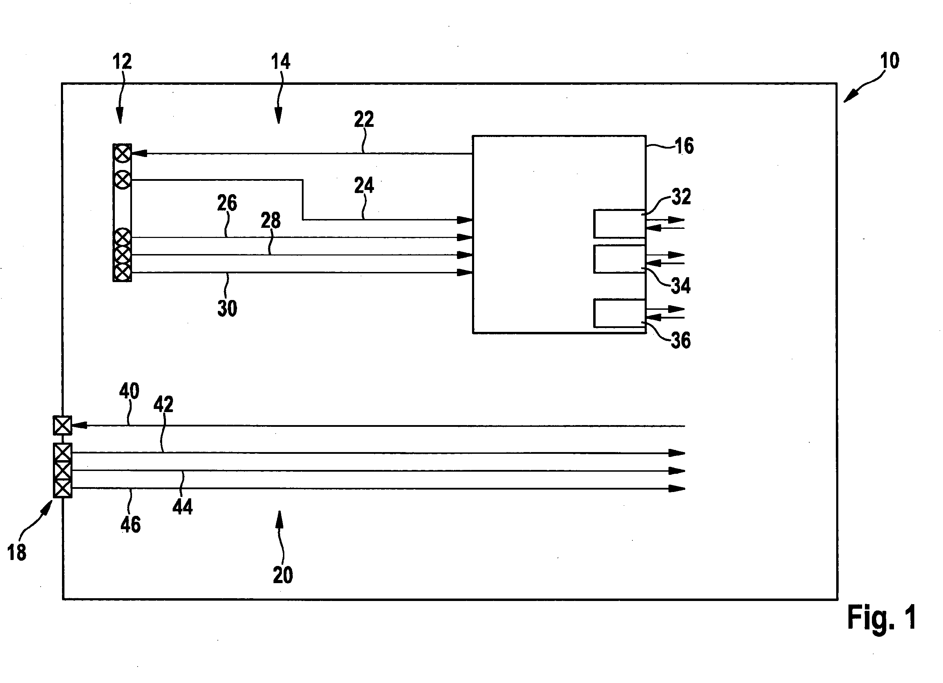

In Figur 1 ist in einem Schaltbild ein integrierter Schaltkreis, insgesamt mit der Bezugsziffer 10 bezeichnet, gemäß dem Stand der Technik dargestellt. Die Darstellung zeigt Testkontaktflächen bzw. Test pads 12, die über einen Testbus 14 mit einem Testanschluss bzw. TAP (Test access port) 16 verbunden sind.

Weiterhin zeigt die Figur 1 Eingabe/Ausgabe-Stifte (IO-Pins) als Steueranschlüsse 18, die mit einem Steuerbus 20 verbunden sind.

Die einzelnen Leitungen des Testbusses 14 sind für Signale vorgesehen, nämlich TDO 22, TRST 24, TCK 26, TMS 28 und TDI 30. Der TAP 16 hat n Ein-Ausgabeanschlüsse, nämlich DR_1 32 für Testdaten, DR_2 34 für ein Setup, ein Stimulieren (Stimulate) und ein Überwachen (Observe) sowie, wie dies dargestellt ist, DR_n 36.

Auch die Leitungen des Steuerbusses 20 sind für Signale vorgesehen, nämlich SO 40, SI 42, CS 44 und CLK 46.

Bei dem in Figur 1 gezeigten Schaltkreis 10 sind der Testbus 14 und der Steuerbus 20 voneinander getrennt. Der Testbus 14 ist nur im unverpackten Schaltkreis 10 im Halbleiterwerk zugänglich. Dort wird der Schaltkreis 10 getestet und verpackt vergossen, so dass danach kein Test mehr möglich ist. Lediglich der Steuerbus 20 wird über die Pins 18 als Verbindung zwischen dem Schaltkreis 10 und einem Mikroprozessor nach außen geführt.

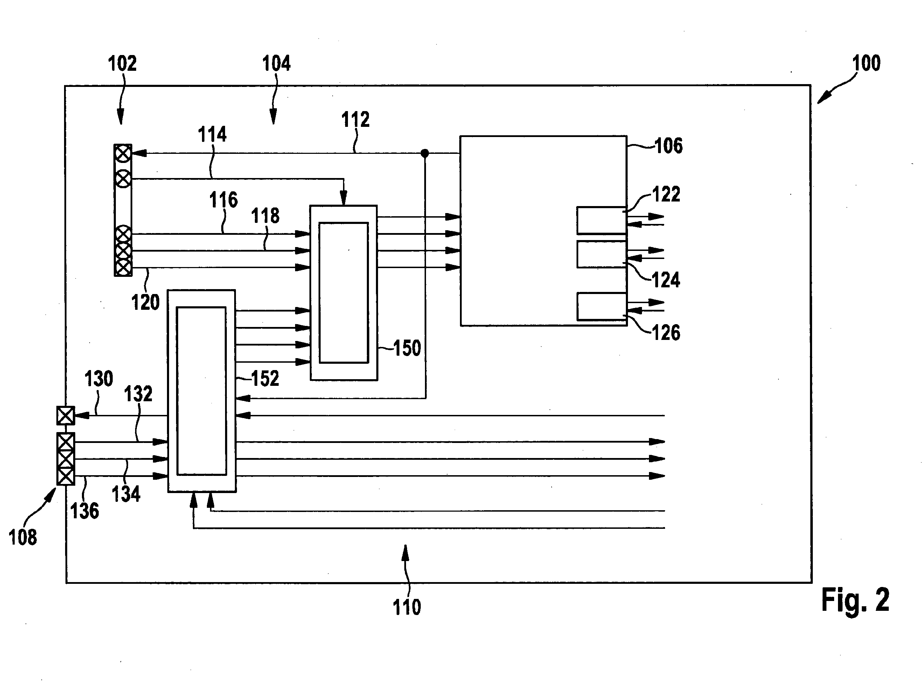

In Figur 2 ist in einem Schaltbild ein integrierter Schaltkreis, insgesamt mit der Bezugsziffer 100 bezeichnet, dargestellt. Die Darstellung zeigt Testkontaktflächen bzw. Test pads 102, die über einen Testbus 104 mit einem Testanschluss bzw. TAP (Test access port) 106 verbunden sind.

Weiterhin zeigt die Figur 2 Eingabe/Ausgabe-Stifte (IO-Pins) als Steueranschlüsse 108, die mit einem Steuerbus 110 verbunden sind.

Die einzelnen Leitungen des Testbusses 104 sind für Signale vorgesehen, nämlich TDO 112, TRST 114, TCK 116, TMS 118 und TDI 120. Der TAP 106 hat n Ein-Ausgabeanschlüsse, nämlich DR_1 122 für Testdaten, DR_2 124 für ein Setup, ein Stimulieren (Stimulate) und ein Überwachen (Observe) sowie, wie dies dargestellt ist, DR_n 126.

Auch die Leitungen des Steuerbusses 110 sind für Signale vorgesehen, nämlich SO 130, SI 132, CS 134 und CLK 136.

Durch Einfügen einer Multiplexerschaltung 150 und 152 wird erreicht, dass der Schaltkreis 100 wie bisher funktioniert.

Zur Einsparung von Gehäusepins werden die SPI-Pins über den Multiplexer 150 und 152 auf den TAP (test access port) 106 geführt. Die Aktivierung des Multiplexers 150 und 152 erfolgt über einen Verriegelungsmechanismus. Dieser Verriegelungsmechanismus ist durch einen speziellen SW-Schlüssel sowie durch die Verwendung einer besonderen Ablaufsteuerung definiert.

Der Verriegelungsmechanismus kann mittels SW-Schlüssel betätigt werden, um zwischen Fahrbetrieb und Testbetrieb umzuschalten.

Nach Aktivierung des Multiplexers werden die physikalisch am ASIC-Gehäuse verfügbaren SPI-Pins auf das interne Test-Interface abgebildet bzw. gemappt. In diesem Ausführungsbeispiel wird der Multiplexer, angesteuert von dem vorstehend erwähnten Verriegelungsmechanismus, wie folgt geschaltet:

SO => TDO

SI => TDI

SCK => TCK

CS => TMS

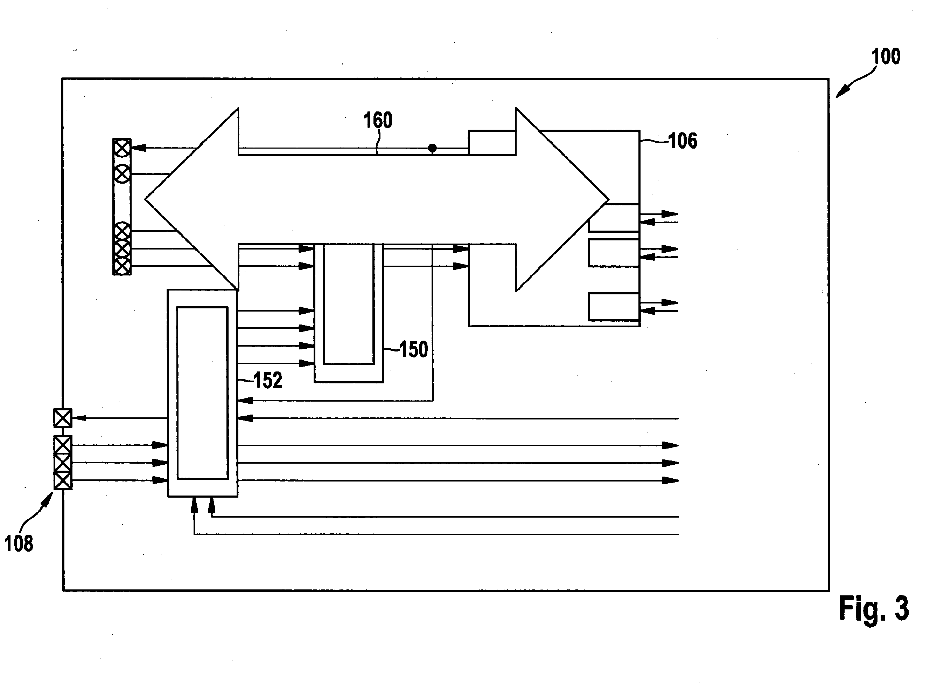

In Figur 3 ist der Schaltkreis 100 aus Figur 2 dargestellt, wobei durch einen Pfeil 160 verdeutlicht ist, dass ein Test wie bisher im Halbleiterwerk durchgeführt werden kann.

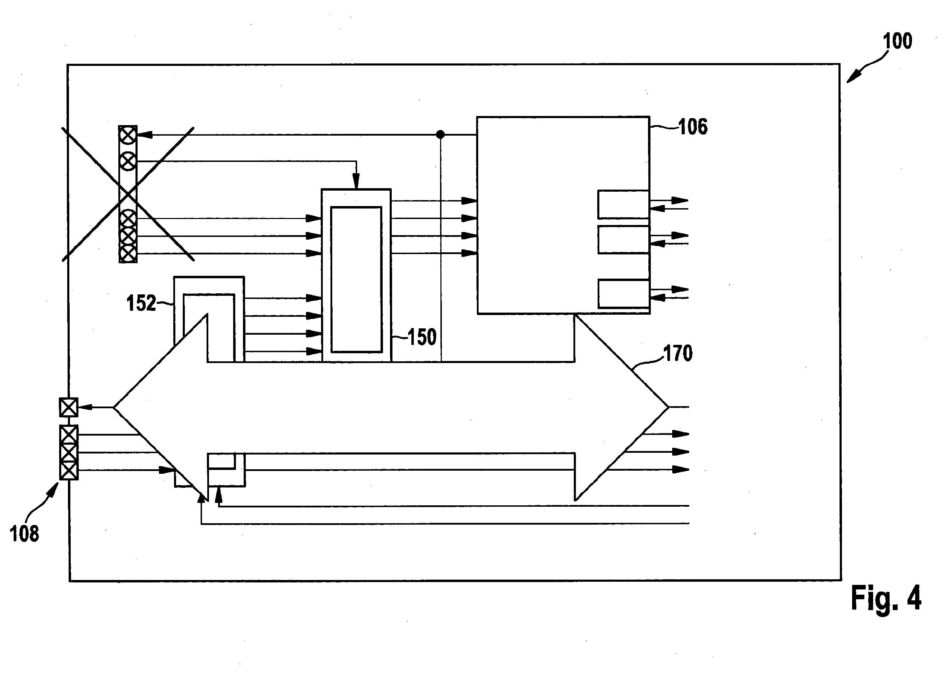

Figur 4 zeigt den Schaltkreis 100, wobei ein Pfeil 170 verdeutlicht, dass der Schaltkreis 100 wie bisher in einem Steuergerät gesteuert wird.

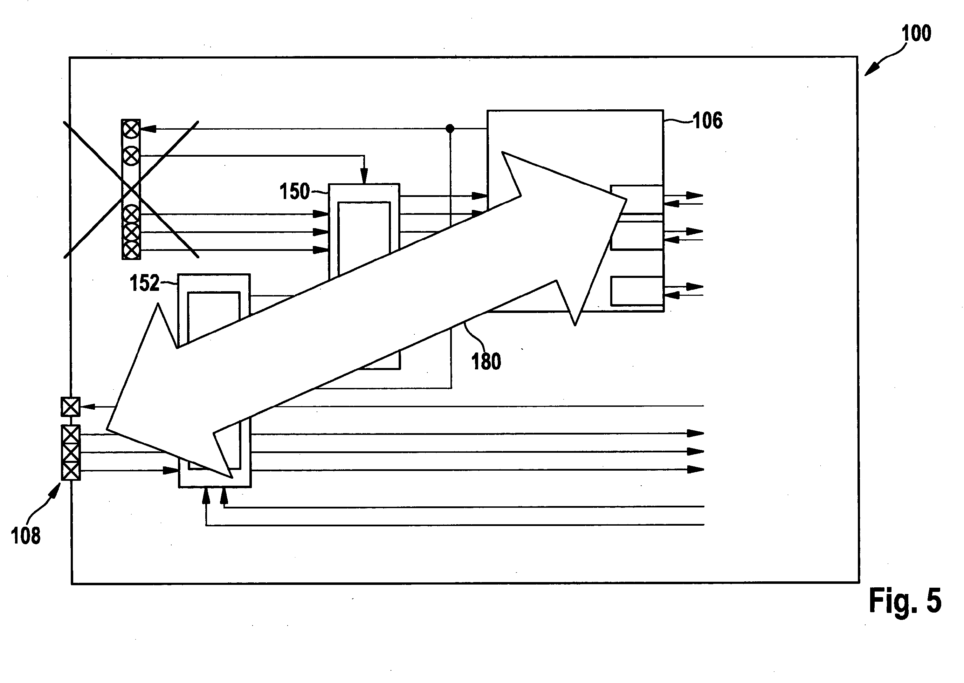

Figur 5 zeigt den Schaltkreis 100 mit der vorgestellten zusätzlichen Nutzung. Ein Pfeil 180 zeigt, wie über das im Steuergerät vorhandene Bussystem der ICinterne TAP 106 vom Mikroprozessor aus gesteuert werden kann, so dass der IC-interne Test durchgeführt werden kann.

Dabei ist wichtig zu beachten, dass unterschieden werden muss, ob sich das Steuergerät im Fahrbetrieb gemäß Figur 4 befindet oder aber, ob das Steuergerät gerade in einer Werkstatt untersucht wird gemäß Figur 5. Hierzu kann ein Verriegelungsmechanismus eingesetzt werden.

Dieser Verriegelungsmechanismus kann sich dadurch auszeichnen, dass dieser in einer definierten Ablaufsteuerung zu erfolgen hat.

Die Erfindung ermöglicht somit einen Selbsttest des Schaltkreises 100, ohne dass ein separater Testbus vorhanden sein muss.

## Patentansprüche

1. Verfahren zum Testen eines integrierten Schaltkreises (100) mit interner Teststruktur, auf die über einen internen Testzuganganschluss (106) zugegriffen werden kann, und mit einem Steuerbus (110), der über Steueranschlüsse (108) nach außen geführt ist, wobei zwischen einem Fahrbetrieb und einem Testbetrieb umgeschaltet werden kann, so dass im Testbetrieb über die Steueranschlüsse (108) und den Steuerbus (110) ein Zugriff auf den Testzuganganschluss (106) und damit ein Testen des integrierten Schaltkreises (100) erfolgt, wobei über einen Multiplexer (150, 152) zwischen dem Fahrbetrieb und dem Testbetrieb umgeschaltet wird, wobei ein Umschalten auf den Testbetrieb durch Eingabe eines Software-Schlüssels bewirkt wird.

2. Verfahren nach Anspruch 1, bei dem ein Verriegelungsmechanismus verwendet wird, der betätigt wird, um zwischen Fahrbetrieb und Testbetrieb umzuschalten.

3. Integrierter Schaltkreis mit interner Teststruktur, auf die über einen internen Testzuganganschluss (106) zugegriffen werden kann, und mit einem Steuerbus (110), der über Steueranschlüsse (108) nach außen geführt ist, wobei zwischen einem Fahrbetrieb und einem Testbetrieb umgeschaltet werden kann, so dass im Testbetrieb über die Steueranschlüsse (108) und den Steuerbus (110) ein Zugriff auf den Testzuganganschluss (106) erfolgt, wobei ein Multiplexer (150, 152) vorgesehen ist, über den das Umschalten zwischen Fahrbetrieb und Testbetrieb erfolgt, wobei das Umschalten auf den Testbetrieb durch Eingabe eines Software-Schlüssels erfolgt.

4. Integrierter Schaltkreis nach Anspruch 3, bei dem als Steuerbus (110) ein SPI-Bus dient.

5. Integrierter Schaltkreis nach Anspruch 3 oder 4, bei dem ein Verriegelungsmechanismus, der ein Umschalten zwischen Fahrbetrieb und Testbetrieb bewirkt, vorgesehen ist.

6. Integrierter Schaltkreis nach Anspruch 3 bis 5, bei dem ein interner Testbus (104) für einen Zugriff auf den Testzuganganschluss (106) vorgesehen ist.

## Claims

1. Method for testing an integrated circuit (100) with an internal test structure, which can be accessed via an internal test access connection (106), and with a control bus (110) which is routed to the outside via control connections (108), wherein it is possible to change over between a driving mode and a test mode, with the result that, in the test mode, the test access connection (106) is accessed via the control connections (108) and the control bus (110) and the integrated circuit (100) is therefore tested, wherein a multiplexer (150, 152) is used to change over between the driving mode and the test mode, wherein changing over to the test mode is effected by inputting a software key.

2. Method according to Claim 1, in which a locking mechanism is used and is actuated in order to change over between the driving mode and the test mode.

3. Integrated circuit with an internal test structure, which can be accessed via an internal test access connection (106), and with a control bus (110) which is routed to the outside via control connections (108), wherein it is possible to change over between a driving mode and a test mode, with the result that, in the test mode, the test access connection (106) is accessed via the control connections (108) and the control bus (110), wherein a multiplexer (150, 152) is provided and is used to change over between the driving mode and the test mode, wherein the changing-over to the test mode is effected by inputting a software key.

4. Integrated circuit according to Claim 3, in which an SPI bus is used as the control bus (110).

5. Integrated circuit according to Claim 3 or 4, in which a locking mechanism which changes over between the driving mode and the test mode is provided.

6. Integrated circuit according to Claims 3 to 5, in which an internal test bus (104) is provided for accessing the test access connection (106).

## Revendications

1. Procédé pour tester un circuit intégré (100) comprenant une structure de test interne, à laquelle on peut accéder par le biais d'un raccord d'accès de test interne (106), et comprenant un bus de commande (110) qui est guidé vers l'extérieur par le biais de raccords de commande (108), une commutation pouvant être effectuée entre un mode de conduite et un mode de test, de telle sorte qu'en mode de test, on puisse accéder au raccord d'accès de test (106) par le biais des raccords de commande (108) et du bus de commande (110), et donc qu'il se produise un test du circuit intégré (100), une commutation pouvant être effectuée par le biais d'un multiplexeur (150, 152) entre le mode de conduite et le mode de test, une commutation au mode de test étant provoquée par saisie d'une clé logicielle.

2. Procédé selon la revendication 1, dans lequel un mécanisme de verrouillage est utilisé, lequel est actionné pour commuter entre le mode de conduite et le mode de test.

3. Circuit intégré comprenant une structure de test, auquel on peut accéder par le biais d'un raccord d'accès de test interne (106), et comprenant un bus de commande (110) qui est guidé vers l'extérieur par le biais de raccords de commande (108), une commutation pouvant être effectuée entre un mode de conduite et un mode de test, de telle sorte qu'en mode de test, il se produise un accès au raccord d'accès de test (106) par le biais des raccords de commande (108) et du bus de commande (110), un multiplexeur (150, 152) étant prévu, par le biais duquel a lieu la commutation entre le mode de conduite et le mode de test, la commutation au mode de test ayant lieu par saisie d'une clé logicielle.

4. Circuit intégré selon la revendication 3, dans lequel on utilise comme bus de commande (110) un bus SPI.

5. Circuit intégré selon la revendication 3 ou 4, dans lequel un mécanisme de verrouillage est prévu, lequel provoque une commutation entre le mode de conduite et le mode de test.

6. Circuit intégré selon les revendications 3 à 5, dans lequel un bus de test interne (104) est prévu pour un accès au raccord d'accès de test (106).
